Europäisches Patentamt

European Patent Office

Office européen des brevets

(11) Publication number: **0 318 956**
**A2**

## EUROPEAN PATENT APPLICATION

(21) Application number: **88119982.2**

(22) Date of filing: **30.11.88**

(51) Int. Cl.4: **G03F 7/08 , G03F 7/26**

(30) Priority: **30.11.87 JP 302462/87**

(43) Date of publication of application:
**07.06.89 Bulletin 89/23**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Tanaka, Hiroyuki Fujitsu Limited**
**Patent Department 1015 Kamikodanaka**
**Nakahara-ku**
**Kawasaki-shi Kanagawa 211(JP)**

(74) Representative: **Greenstreet, Cyril Henry et al**
**Haseltine Lake & Co. Hazlitt House 28**
**Southampton Buildings Chancery Lane**
**London WC2A 1AT(GB)**

(54) **Positive-working photoresist compositions and use thereof for forming positive-tone relief images.**

(57) In dry development by selective silylation and dry etching, a positive photosensitive resist material which is sensitive to a beam of deep UV radiation is used to form a positive resist pattern. The positive photosensitive resist material contains a resin having a phenolic hydroxyl group such as a novolac resin and a compound having, within the molecule, an aromatic ring having a sulphonyl halide group but not having a phenolic hydroxyl group, such as a 1,2-quinone diazide sulphonyl halide. A method of forming a positive resist pattern comprises coating a substrate with the positive photosensitive resist material, exposing the determined pattern to the substrate with a beam of deep UV radiation, thereafter selectively silylating the unexposed region, then dry etching using an oxygen plasma with the silylated region used as a mask. A fine resist pattern, which is suitable as the mask in the semiconductor manufacturing process and has excellent dry etching resistivity, can be formed easily.

Fig 1 (C)

## Positive-working photoresist compositions and use thereof for forming positive-tone relief images.

The present invention relates to a novel positive photosensitive resist material suitable for formation of a pattern by photolithography using a deep UV beam such as an ultraviolet excimer laser beam and to a novel method for forming a positive resist pattern. More specifically, this invention relates to a novolac system photosensitive resist which shows high sensitivity to a deep UV beam such as an ultraviolet excimer laser beam and has excellent dry etching resistivity and to a method for forming a fine positive resist pattern having sharp side surfaces and a high aspect ratio by conducting a dry development process combining selective silylation and dry etching after exposing the photosensitive resist used.

In a process for manufacturing fine semiconductor devices such as a semiconductor integrated circuit, a resist pattern is formed by photolithography on a semiconductor substrate and processing steps such as etching or impurity doping are conducted thereof using the resist pattern as the mask.

With recent progress in high integration and packing density of semiconductor integrated circuits (IC), a minimum size of constitution elements of 0.5 μm or less has been made a reality in experimental manufacture. In the etching process for manufacturing such ICs, the dry etching technique, represented by reactive ion etching (RIE) which realises fine process with less lateral etching, has been widely employed.

In this connection, a technology to form a fine resist pattern having dry etching resistivity is now required. Since miniaturisation of the pattern is optically limited in photolithography using g line (wavelength: 436 nm) and i line (wavelength: 364 nm), the use of a method using a deep UV beam such as an ultraviolet ray excimer laser beam with a wavelength of 300 nm or less in place of the photolithography has been considered. Therefore, it is required to develop a method to form a fine resist pattern using such material.

It is effective for increasing resolution in photolithography to make the wavelength of the light beam used for exposure short and to use a large numerical aperture (NA) such as lenses of the optical system of the exposure apparatus, but as a result the depth of focus, on the other hand, becomes shallow.

Therefore, it is essential for obtaining a fine resist pattern that the photosensitive resist layer be flat and thin. However, when a resist layer is formed as a thin layer, resistivity is degraded and a sufficient flatness is no longer acquired in case there is a stepped portion on the substrate. Thus, it becomes difficult to obtain a clear pattern. On the contrary, when the resist layer is formed as a thick layer in order to improve resistivity when used as a mask and to improve the flatness of the resist layer, the resolution is then impaired.

A known method for solving such problems is to use a resist layer of a multilayer structure and realise dry development by anisotropic etching.

In this known method, a substrate is first coated with a thick layer of a first organic resist layer to bury the stepped portion thereof and to obtain a flat surface. Thereafter, a second resist layer consisting of a photosensitive resist containing silicon and having good dry etching resistivity is formed on the flat first organic resist layer, and a dry etching mask is formed by patterning the desired pattern on the second resist layer through exposure and development. In place of using the photosensitive resist containing silicon, a layer such as spin-on-glass (SOG) is formed on the first organic resist layer and a second photosensitive resist layer is formed thereon. After patterning by exposing and developing the desired pattern on the second resist layer, the SOG layer is etched, in some cases, with the pattern being used as the mask to form the mask for dry etching. A resist pattern which works as the mask in the successive processes can be formed by dry-etching the first organic resist layer by oxygen plasma using the mask formed as explained previously.

The method of using such a resist layer having a multilayer structure provides the advantage that a large degree of freedom in photolithography is possible because it can freely combine the first resist layer which determines the characteristics of the resist pattern as the mask and the second resist layer which is required to have photosensitivity and resolution. For instance, this method can be applied easily to photolithography using an ultraviolet ray excimer laser beam as the light source by using a first organic resist layer having excellent dry etching resistance and a second photosensitive resist having high sensitivity and resolution to an ultraviolet ray excimer laser beam of a wavelength of 300 nm or less.

However, this method has the disadvantage that at least two resist processes are essential and the processes are thereby complicated. The photosensitive resist containing silicon is generally negative and tends to swell in the process of development like other negative photosensitive resists. Therefore, there has been a limit in miniaturisation of resist patterns so long as such photosensitive resists are used.

Accordingly, as a method for simplifying the photolithography processes, it has been proposed that a single layer of a photosensitive resist layer is formed, a desired pattern is exposed thereon, thereafter selective silylation is carried out and finally dry development is carried out.

In the case of this latter method, the substrate is first coated with a thick photosensitive resist to bury the stepped portion of the substrate and assure a flat surface thereof. Next, after the determined pattern is exposed on this photosensitive resist layer, a silylating agent, e.g. hexamethyl disilazane (HMDS) or silicon tetrachloride (SiCl₄) is used to selectively silylate the exposed region or unexposed region. Thereby, a resist region containing silicon having improved dry etching resistivity can be formed. With a resist region containing silicon used as the mask, the dry development is conducted using oxygen plasma as explained previously. Thereby, a resist pattern which serves as the mask in the successive processes can be formed.

Formation of negative resist patterns through reaction of HMDS with a photoresist sensitive to the g line and i line in this method is described in the article by F. Coopmans and B. Roland: "DESIRE: A New Route to Submicron Optical Lithography", Solid State Technology (1987), pages 93-99. Formation of negative resist patterns through reaction of HMDS with a resist of a styrene derivative or acrylate base sensitive to deep UV and X-rays is also described in Japanese Laid-open Patent Publication No. 61-138255 (1986) based on U.S. Patent Application No. 679 527.

Moreover, formation of positive resist patterns through reaction of SiCl₄ with an isoprene resist including bis-azide sensitiser sensitive to deep UV by a similar method is described in a paper by T. M. Wolf, G. N. Raylor, T. Venkatesan and R. T. Kraetsch: "The Scope and Mechanism of New Positive Tone Gas-Phase-Functionalized Plasma-Developed Resists", J. Electrochem. Soc., Vol. 131 (1984), pages 1644-1670.

In these methods, the resist process is conducted once and therefore the photolithography process is simplified but, on the other hand, it is impossible to selectively use resist layers of different characteristics as in the case of using the multilayer structure resist layer.

In case a positive novolac system photosensitive resist having high resolution and excellent dry etching resistivity is used as the photosensitive resist, a good resist pattern may be formed for the near and mid-UV such as g line or i line but a good resist pattern cannot be obtained for the deep UV such as an ultraviolet excimer laser beam. Moreover, only a negative pattern can be obtained. The resist based on a styrene derivative or acrylate which is sensitive to deep UV and X-ray has high resolution and provides a good negative pattern but is generally inferior in sensitivity and dry etching resistivity to the novolac type resist.

A positive resist pattern can be formed through exposure by deep UV using an isoprene type resist and SiCl₄ but a lot of residue remains on the substrate after the dry development, resulting in a problem for practical use.

So far as the inventor of the present invention is aware, a photosensitive resist which allows use of a dry development process using selective silylation and provides high sensitivity and resolution to a deep UV beam such as an ultraviolet excimer laser beam and excellent dry etching resistivity has not yet been proposed.

More particularly, a novolac photosensitive resist which forms a positive resist pattern by a dry development process utilising selective silylation is not yet known.

The present invention is based on the discovery by the inventor that in the presence of certain additive compounds the silylation of novolac-type photosensitive resists is suppressed in the region irradiated, e.g. by a laser beam, unlike a conventional novolac-type photosensitive resist.

Embodiments of the present invention can provide a positive photosensitive resist material which has high sensitivity to an ultraviolet excimer laser beam, excellent dry etching resistivity and high resolution.

Embodiments of the present invention can also provide a method for forming a fine positive resist pattern using such a photosensitive resist.

In embodiments of the invention, additive compounds may be used having, within the molecule, an aromatic ring having a sulphonyl halide group, and not having a phenolic hydroxyl group, such as 1,2-naphthoquinone diazide sulphonyl halide, and a positive photosensitive resist material containing a resin having an aromatic ring and having a phenolic hydroxyl group such as a novolac resin. Irradiation may e.g. be performed with a KrF excimer laser beam with a wavelength of 248 nm. Embodiments of the present invention also provide a process to form a resist layer by coating the substrate with the positive photosensitive resist material, a process to expose and draw the predetermined pattern on this resist layer, a process to selectively silylate the region not exposed during a gas phase treatment with a silylating agent such as HMDS, and a process for forming a positive resist pattern through dry etching with the silylated region used as the mask.

In the case of a positive photosensitive resist material of the present invention, when the material is irradiated with a deep UV beam such as KrF excimer laser beam with a wavelength of 248 nm and is acted on by the silylation agent, silylation is suppressed at the part irradiated with the beam, contrary to a conventional novolac system photosensitive resist, and as a result the part not irradiated with the beam is selectively silylated. With dry etching using an oxygen plasma with such a silylated region used as the mask, a positive resist pattern can be obtained. The resist of the present invention is based on a novolac resin and therefore the dry etching resistivity is, similar to the conventional novolac photosensitive resist, excellent.

By means of the present invention, a fine resist pattern which is suitable as a mask in a semiconductor manufacturing process and has excellent dry etching resistivity can be formed easily and, therefore, a semiconductor integrated circuit can be further miniaturised.

Further objects, structures and effects of the present invention will be explained in detail with reference to the accompanying drawings, in which:

Fig. 1(a)-(c) are schematic diagrams illustrating the processes for forming a positive resist pattern using a positive photosensitive resist material of the present invention; and

Fig. 2 illustrates the sensitivity curve of a pattern-forming material of an embodiment of the present invention.

An embodiment of the present invention is based on the discovery that when a resist layer containing a novolac resin and quinone diazide sulphonyl halide is irradiated with a KrF excimer laser with a wavelength of 248 nm, silylation is suppressed in the part exposed to the excimer laser, unlike the known positive photosensitive resists, e.g. a novolac resist containing an ester of a naphthoquinone diazide compound.

The mechanism of silylation suppression by irradiation of the resist compound containing a novolac resin and a quinone diazide sulphonyl halide with a deep UV beam has not been determined exactly, but it is believed that the phenolic hydroxyl group existing in the benzene ring of the novolac resin and the quinone diazide sulphonyl halide may react, due to irradiation of the deep UV beam, to form a sulphonate coupling or indene carboxylic acid coupling thereby reducing the amount of the phenolic hydroxyl group available for contributing to the silylation of the novolac group.

As the resin material used for the positive photosensitive resist material of the present invention, a resin containing a phenolic hydroxyl group which becomes the site for silylation may be used. Additionally, because a resist based on a resin containing a large amount of aromatic rings within the molecule has better dry etching resistivity, it is most desirable to use a novolac resin as the resin material for the positive photosensitive resist material of the present invention. The novolac resin useful in the present invention is formed by condensation of phenol materials and aldehyde materials. As the phenol materials, phenol, cresol, xylenol, ethylphenol, butylphenol, phenylphenol, allylphenol, pyrocatechol, resorcinol, hydroquinone and pyrogallol may be used. These phenols are used alone or in the form of a mixture of two or more kinds. As the aldehydes, formaldehyde and acetaldehyde may be used.

The compound combined with the resin material should react with the phenolic hydroxyl group of the resin through irradiation with a deep UV beam and should not be silylated. As this compound, as explained above, a compound having a sulphonyl halide group and an aromatic ring having no phenolic hydroxyl group within the molecule is preferred. Particularly, quinone diazide sulphonyl halides are preferred. As the quinone diazide sulphonyl halide, the following are representative:

1,2-naphthoquinone diazide-4-sulphonyl halide
1,2-naphthoquinone diazide-5-sulphonyl halide
1,4-naphthoquinone diazide sulphonyl halide
1,2-benzoquinone diazide-4-sulphonyl halide
1,2-benzoquinone diazide-5-sulphonyl halide
1,4-benzoquinone diazide sulphonyl halide
1,2-benzoquinone diazide-4-chlor-6-sulphonyl halide
1,2-anthraquinone diazide sulphonyl halide or quinone diazide sulphonyl halide having an anthracene ring or phenanthrene ring
1,4-anthraquinone diazide sulphonyl halide
9,10-anthraquinone diazide sulphonyl halide
1,2-phenanthrenequinone diazide sulphonyl halide
1,4-phenanthrenequinone diazide sulphonyl halide
9,10-phenanthrenequinone diazide sulphonyl halide.

The amount of the additive compound is preferably selected to be an amount sufficient to react with the total amount of phenolic hydroxyl groups contained in the resin materials used.

The photosensitive resist material of the present invention is used by dissolving the resin material and additive compound in a solvent. As a solvent, those which have a large solubility for the resin material and additive compound and are volatile are desirable. The solvents used for conventional novolac photosensitive resists are also useful in the present invention. As such solvents as mentioned above the following are representative:

glycol ethers such as
ethyleneglycolmonomethyl-ether
Cellosolve acetate such as methyl Cellosolve acetate
esters such as butyl acetate
aromatic group hydrocarbons such as toluene and xylene

ketones such as methylethylketone

ethers such as benzylethylether

alcohols such as octanol and benzylalcohol

fatty acids such as caproic acid.

These solvents are used alone or in a combination of two or more kinds.

Moreover, it is also possible to add, as required, a conservatory stabiliser, surface active agent and a pigment to the positive photosensitive resist material of the present invention.

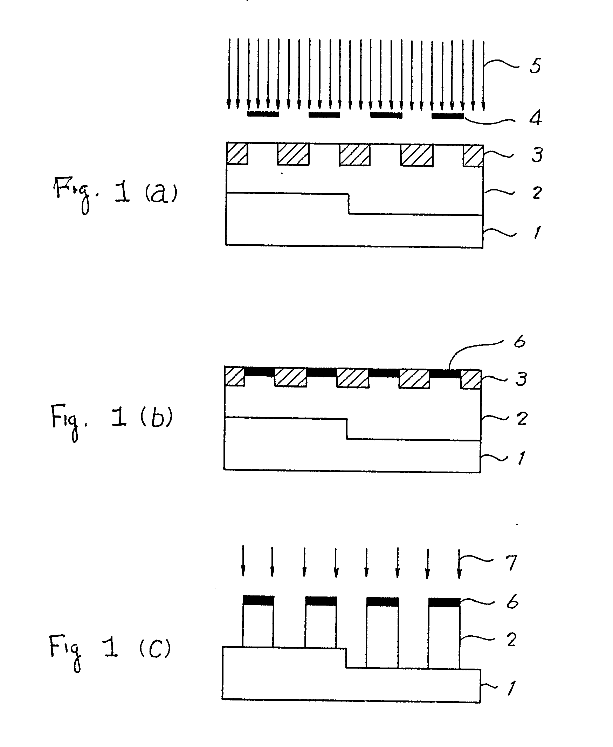

Figs. 1(a)-(c) illustrate the process steps for forming a positive resist pattern by a dry development process including selective silylation and dry etching using the positive photosensitive resist material of the present invention.

The positive resist pattern of the present invention may be formed in the following procedures.

First, the substrate 1 is coated with a thick layer of the positive photosensitive pattern-forming material of the present invention to fill the stepped portion on the substrate and form a resist layer 2 having a flat surface. Then, with a mask 4 of a predetermined pattern and reticle, the resist layer is irradiated with a deep UV beam 5 such as a KrF excimer laser. Thereby, the exposed region 3 is hardened depending on the pattern as illustrated in Fig. 1(a). When the resist layer 2 is silylated with a silylating agent such as HMDS, as illustrated in Fig. 1(b), the region not exposed to the laser beam is selectively silylated, forming the silylated regions 6. In this step, the surface of the exposed regions is also silylated, to form a very thin silylated layer (not illustrated). Therefore, the entire surface of the resist layer 2 is slightly sputter-etched to remove the thin silylated layer at the surface of the exposed regions. In this case, it is very important that the etching is not excessive in order to prevent a reduction in the thickness of the silylated regions 6 of the unexposed areas. Next, the resist layer is irradiated with an oxygen plasma 7 for anisotropic etching. Thereby, the silylated regions 6 act as a mask and the unsilylated regions, namely the regions irradiated with the laser beam, are removed and the unexposed parts of the resist layer, i.e. the areas not irradiated with the beam, are left as shown in Fig. 1(c), thereby forming the positive resist pattern.

With the method explained above, a positive resist pattern can be obtained from the positive photosensitive resist material of the present invention utilising a deep UV beam with a wavelength of 300 nm or less for the exposure. Accordingly, it is also possible to use an ArF excimer laser beam or a synchronotron orbital radiation (SOR) beam for the exposure in addition to the KrF excimer laser beam.

In the method for forming a resist pattern of the present invention, a novolac system photosensitive resist having high sensitivity and resolution is used and anisotropic dry etching is used in the development. Thus, a fine positive resist pattern having sharp side surfaces and a large aspect ratio can be obtained.

The present invention will now be explained more specifically with embodiments thereof but the present invention is not to be limited to such embodiments.

Example 1

A photosensitive resist material as an embodiment of the present invention was prepared by dissolving phenol novolac resin (100 parts by weight) (average molecular weight: about 5000) and 1,2-naphthoquinone diazide-5-sulphonylchloride (20 parts by weight) in ethoxyethylacetate (260 parts by weight).

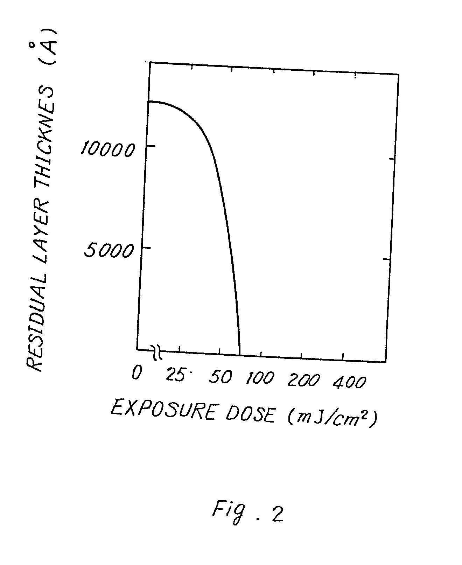

The sensitivity curve for a KrF excimer laser having a wavelength of 248 nm when this photosensitive resist material is dry-developed by selective silylation and dry etching is shown in Fig. 2. As is apparent from the Figure, this pattern formation material is positive and its sensitivity is 70 mJ/cm$^2$. The results shown in Fig. 2 were obtained by the following procedures.

First a silicon substrate was coated with the positive photosensitive pattern-forming material with a spinner under the condition of 4000 rpm. Thereafter, the substrate is baked for 90 seconds at 100°C in a dry nitrogen gas atmosphere and thereby a resist layer of a thickness of 12000Å is formed. In this embodiment, a stylus contact-type step-height measuring instrument (type DEKTAK IIA, manufactured by Sloan Technology Corporation) is used.

Thereafter, the resist layer was irradiated with the KrF excimer laser beam of a wavelength of 248 nm while changing the amount of exposure in the range of 0 ~ 400 mJ/cm$^2$.

Next, the housings for the substrate and HMDS are put, without direct contact between them, into a case with a cover. This case is then heated for 40 minutes at 140°C within a convection oven for the silylation.

After the silylation, etching by oxygen plasma was carried out for 2 minutes using the well-known RIE apparatus under the conditions that oxygen gas flow rate was 60 sccm, pressure was 0.03 Torr and power density was 1.6 W/cm$^2$.

After this dry etching, film thickness of the remaining resist layer was measured with the step-height measuring apparatus.

Example 2

The positive photosensitive resist material used in Example 1 was irradiated with the i line of a mercury lamp (365 nm) in place of the KrF excimer laser beam (248 nm) for the silylation and dry etching in the same way. Thereby, the negative resist pattern can be obtained. With this phenomenon, both negative and positive resist patterns can be formed only by changing the wavelength of the beam used for the exposure.

Example 3

As the positive photosensitive resist material, the material used in Example 1 was used. With the same procedures as explained previously for the embodiment of the present invention, a resist layer was formed on the silicon substrate in a thickness of 1.0 ~ 1.4 $\mu$m. A line and space pattern in different widths was exposed to the substrate under the condition of 140 mJ/cm$^2$ using the reduction projection exposing apparatus (NA: 0.35, spectrum width FWHM: 0.006 nm) using the KrF excimer laser as the light source. Thereafter, in the same way as the embodiment explained previously, silylation was carried out, the entire part of the surface was etched with a mixed gas plasma of $O_2/CF_4$ under conditions of an $O_2$ flow rate of 20 sccm, a $CF_4$ flow rate of 100 sccm and a pressure of 0.17 Torr. Thereafter, dry development was conducted by the oxygen plasma etching under the same conditions as that explained above. Observation of the resist pattern with a scanning electron microscope proved that a clear resist pattern with a line and space of 0.5 $\mu$m and an aspect ratio of 2-3 can be obtained. The side surface is almost perpendicular to the upper surface and deformation of the pattern almost cannot be observed.

Moreover, almost the same result has also been obtained with the use of 1,2-naphthoquinone diazide-4-sulphonyl chloride and 1,2-benzoquinone diazide-4-sulphonyl-chloride. Moreover, compounds obtained by replacing the halogen group of these compounds with a bromine atom or iodine atom can also be used in the positive photosensitive resist material.

**Claims**

1. A positive-working lithographic resist composition developable by a combination of silylation and etching using plasma, comprising:

(a) a film-forming resin material, having a phenolic hydroxyl group acting as a reaction site for silylation; and

(b) an additive compound containing, in the molecular structure, an aromatic ring having a sulphonyl halide group but not having a phenolic hydroxyl group.

2. A positive-working lithographic resist composition according to claim 1, further comprising a solvent.

3. A positive-working lithographic resist composition according to claim 1 or 2, wherein the resin material is a novolac resin.

4. A positive-working lithographic resist composition according to any preceding claim, wherein the additive compound is a quinone-diazide compound.

5. A positive-working lithographic resist composition according to claim 4, wherein the quinone-diazide compound is selected from the group consisting of

1,2-benzoquinone-(2)-diazide-4-sulphonyl halide
1,2-benzoquinone-(2)-diazide-5-sulphonyl halide
1,2-benzoquinone-(2)-diazide-4-chlor-6-sulphonyl halide
1,4-benzoquinone-(4)-diazide-sulphonyl halide
1,2-naphthoquinone-(2)-diazide-4-sulphonyl halide
1,2-naphthoquinone-(2)-diazide-5-sulphonyl halide
1,4-naphthoquinone-(4)-diazide-sulphonyl halide
1,2-anthraquinone-(2)-diazide-sulphonyl halide
1,4-anthraquinone-(4)-diazide-sulphonyl halide
9,10-anthraquinone-(10)-diazide-sulphonyl halide
1,2-phenanthrenequinone-(2)-diazide-sulphonyl halide
1,4-phenanthrenequinone-(4)-diazide-sulphonyl halide
9,10-phenanthrenequinone-(10)-diazide-sulphonyl halide.

6. A positive-working lithographic resist composition according to claim 4 or claim 5, wherein the quinone-diazide-sulphonyl halide is a chloride.

7. A positive-working lithographic resist composition according to claim 4 or claim 5, wherein the quinone-diazide-sulphonyl halide is a bromide.

8. A positive-working lithographic resist composition according to claim 4 or claim 5, wherein the quinone-diazide-sulphonyl halide is an iodide.

9. A method of forming a positive-tone resist pattern on a substrate, comprising the steps of:

(a) forming on said substrate a resist film having a composition according to any preceding claim;

(b) exposing said resist film patternwise to actinic radiation;

(c) treating said resist film with a silylating agent to silylate an unexposed portion thereof; and

(d) developing said film by etching with a plasma containing oxygen, so as to obtain a positive-tone resist pattern.

10. A method according to claim 9, wherein step (a) comprises a substep of baking the resist film.

11. A method according to claim 9 or claim 10, wherein said radiation has a wavelength less than 300 nm.

Fig. 1 (a)

Fig. 1 (b)

Fig 1 (c)

Fig . 2